# NEUE EUROPÄISCHE PATENTSCHRIFT

(11) **EP 2 708 091 B2**
(45) Veröffentlichungstag und Bekanntmachung des Hinweises auf die Entscheidung über den Einspruch: **23.06.2021**
(45) Hinweis auf die Patenterteilung: 20.12.2017
(21) Anmeldenummer: 12714016.8
(22) Anmeldetag: 17.04.2012
(51) Int. Cl.: H05B 3/84, H01R 4/62

(54) **SCHEIBE MIT EINEM ELEKTRISCHEN ANSCHLUSSELEMENT**
DISK HAVING AN ELECTRIC CONNECTING ELEMENT
VITRE MUNIE D'UN ÉLÉMENT DE RACCORDEMENT ÉLECTRIQUE

(30) Priorität: 10.05.2011 EP 11165501; 10.05.2011 EP 11165506
(43) Veröffentlichungstag der Anmeldung: 19.03.2014
(73) Patentinhaber: SAINT-GOBAIN GLASS FRANCE, 92400 Courbevoie (FR)
(72) Erfinder: CHOLEWA, Harald, 52064 Aachen (DE); DEGEN, Christoph, 52072 Aachen (DE); REUL, Bernhard, 52134 Herzogenrath (DE); RATEICZAK, Mitja, 52146 Würselen (DE); SCHLARB, Andreas, 52134 Herzogenrath (DE); LESMEISTER, Lothar, NL-6373 Landgraaf (NL)
(74) Vertreter: Gebauer, Dieter Edmund
(86) Internationale Anmeldenummer: PCT/EP2012/056964
(87) Internationale Veröffentlichungsnummer: WO 2012/152543

(56) Entgegenhaltungen:
- EP-A1- 2 365 730
- EP-A1- 2 408 260
- EP-A2- 0 720 253
- WO-A1-01/99472
- DE-A1-102006 017 675
- JP-A- 2001 102 151
- US-A- 2 644 066
- US-A- 2 644 066
- US-A- 3 204 326
- US-A- 4 498 096
- US-A- 5 748 155
- US-A- 5 902 536
- US-A1- 2006 102 610
- US-A1- 2007 224 842
- US-A1- 2007 224 842
- US-A1- 2010 020 380
- US-B1- 6 406 337
- US-B1- 6 816 385
- US-B1- 7 658 617
- US-B2- 6 396 026

## Beschreibung

Die Erfindung betrifft eine Scheibe für Fahrzeuge mit einem elektrischen Anschlusselement und ein wirtschaftliches und umweltfreundliches Verfahren zu deren Herstellung.

Die Erfindung betrifft weiter eine Scheibe für Fahrzeuge mit einem elektrischen Anschlusselement mit elektrisch leitfähigen Strukturen, nämlich Heizleiter oder Antennenleiter. Die elektrisch leitfähigen Strukturen sind üblicherweise über angelötete elektrische Anschlusselemente mit der Bordelektrik verbunden. Aufgrund unterschiedlicher thermischer Ausdehnungskoeffizienten der verwendeten Materialien treten mechanische Spannungen bei der Herstellung und im Betrieb auf, welche die Scheiben belasten und den Bruch der Scheibe hervorrufen können.

Bleihaltige Lote weisen eine hohe Duktilität auf, die auftretende mechanische Spannungen zwischen elektrischem Anschlusselement und der Scheibe durch plastische Deformierung kompensieren können. Allerdings müssen aufgrund der Altauto-Richtlinie 2000/53/EG innerhalb der EG bleihaltige Lote durch bleifreie Lote ersetzt werden. Die Richtlinie wird zusammenfassend mit dem Kürzel ELV (End of life vehicles) bezeichnet. Das Ziel ist dabei, im Zuge der massiven Ausweitung von Wegwerfelektronik äußerst problematische Bestandteile aus den Produkten zu verbannen. Die betroffenen Substanzen sind Blei, Quecksilber und Cadmium. Das betrifft unter anderem die Durchsetzung von bleifreien Lötmitteln in elektrischen Anwendungen auf Glas und die Einführung entsprechender Ersatzprodukte hierzu.

EP 1 942 703 A2 offenbart ein elektrisches Anschlusselement an Scheiben von Fahrzeugen, wobei die Differenz der thermischen Ausdehnungskoeffizienten von Scheibe und elektrischem Anschlusselement < 5 x 10⁻⁶/°C beträgt und das Anschlusselement überwiegend Titan enthält. Um eine ausreichende mechanische Stabilität und Prozessierbarkeit zu ermöglichen wird vorgeschlagen, einen Lotmassenüberschuss zu verwenden. Der Überschuss an Lotmasse tritt aus dem Zwischenraum zwischen dem Anschlusselement und elektrisch leitfähiger Struktur heraus. Der Überschuss an Lotmasse verursacht hohe mechanische Spannungen in der Glasscheibe. Diese mechanischen Spannungen führen schließlich zum Bruch der Scheibe. Zudem ist Titan schlecht lötbar. Dies führt zu einer schlechten Haftung des Anschlusselementes an der Scheibe. Das Anschlusselement muss außerdem mit der Bordelektrik über ein elektrisch leitfähiges Material, beispielsweise Kupfer, verbunden werden, etwa durch Verschweißen. Titan ist schlecht schweißbar.

Das Dokument US 2007/224842 A1 beschreibt eine Scheibe mit mindestens einem elektrischen Anschlusselement, umfassend ein Substrat, eine elektrisch leitfähige Struktur auf einem Bereich des Substrats, ein Anschlusselement aus einer Eisen-Nickel-Legierung oder Titanlegierung mit einem niedrigen thermischen Ausdehnungskoeffizienten, und eine Schicht einer bleifreien Lotmasse, die das Anschlusselement mit Teilbereichen der elektrisch leitfähigen Struktur elektrisch verbindet.

Das Dokument US 2644066 zeigt ein Anschlusselement, das mit einer bleihaltigen Lotmasse mit einer elektrisch leitfähigen Struktur verbunden ist.

Die Aufgabe der vorliegenden Erfindung ist es, eine Scheibe mit einem elektrischen Anschlusselement und ein wirtschaftliches und umweltfreundliches Verfahren zu deren Herstellung bereitzustellen, wobei kritische mechanische Spannungen in der Scheibe vermieden werden.

Die Aufgabe der vorliegenden Erfindung ist weiter, ein im Vergleich zum Stand der Technik verbessertes Material für das Anschlusselement bereitzustellen, welches eine bessere Verfügbarkeit und bessere Verarbeitbarkeit, wie Lötbarkeit, Schweißfähigkeit und Kaltumformbarkeit hat.

Die Aufgabe der vorliegenden Erfindung wird erfindungsgemäß durch eine Vorrichtung gemäß dem unabhängigen Anspruch 1 gelöst. Bevorzugte Ausführungen gehen aus den Unteransprüchen hervor.

Die erfindungsgemäße Scheibe mit mindestens einem Anschlusselement umfasst die folgenden Merkmale:
- ein Substrat aus Glas,
- eine elektrisch leitfähige Struktur auf einem Bereich des Substrats, wobei die elektrisch leitfähige Struktur ein Heizleiter oder Antennenleiter ist,
- ein Anschlusselement, wobei das Anschlusselement zumindest einen chromhaltigen Stahl enthält und
- eine Schicht einer bleifreien Lotmasse, die das Anschlusselement mit Teilbereichen der elektrisch leitfähigen Struktur elektrisch verbindet.

Das Substrat ist aus Glas, besonders bevorzugt Flachglas, Floatglas, Quarzglas, Borosilikatglas, Kalk-Natron-Glas.

Das Substrat weist einen ersten thermischen Ausdehnungskoeffizienten auf. Das Anschlusselement weist einen zweiten thermischen Ausdehnungskoeffizienten auf. In einer vorteilhaften Ausgestaltung der Erfindung ist die Differenz zwischen dem ersten und dem zweiten Ausdehnungskoeffizienten < 5 x 10⁻⁶/°C. Dadurch wird eine bessere Haftung erhalten.

Auf der Scheibe ist eine elektrisch leitfähige Struktur aufgebracht. Ein elektrisches Anschlusselement ist mit einer Lotmasse auf Teilbereichen mit der elektrisch leitfähigen Struktur elektrisch verbunden. Die Lotmasse tritt mit einer Austrittsbreite von < 1 mm aus dem Zwischenraum zwischen dem Anschlusselement und der elektrisch leitfähigen Struktur aus.

In einer bevorzugten Ausgestaltung ist die maximale Austrittsbreite bevorzugt kleiner 0,5 mm und insbesondere etwa 0 mm. Das ist besonders vorteilhaft im Hinblick auf die Reduzierung von mechanischen Spannungen in der Scheibe, die Haftung des Anschlusselements und die Einsparung des Lots.

Die maximale Austrittsbreite ist definiert als der Abstand zwischen den Außenkanten des Anschlusselementes und der Stelle des Lotmasseübertritts, an dem die Lotmasse eine Schichtdicke von 50 µm unterschreitet. Die maximale Austrittsbreite wird nach dem Lötvorgang an der erstarrten Lotmasse gemessen.

Eine gewünschte maximale Austrittsbreite wird durch eine geeignete Wahl von Lotmassenvolumen und lotrechtem Abstand zwischen Anschlusselement und elektrisch leitfähiger Struktur erreicht, was durch einfache Versuche ermittelt werden kann. Der lotrechte Abstand zwischen Anschlusselement und elektrisch leitfähiger Struktur kann durch ein entsprechendes Prozesswerkzeug, beispielsweise ein Werkzeug mit einem integrierten Abstandshalter, vorgegeben werden.

Die maximale Austrittsbreite kann auch negativ sein, also in den von elektrischem Anschlusselement und elektrisch leitfähiger Struktur gebildeten Zwischenraum zurückgezogen sein.

In einer vorteilhaften Ausgestaltung der erfindungsgemäßen Scheibe ist die maximale Austrittsbreite in dem vom elektrischen Anschlusselement und der elektrisch leitfähigen Struktur gebildeten Zwischenraum in einem konkaven Meniskus zurückgezogen. Ein konkaver Meniskus entsteht beispielsweise durch Erhöhen des lotrechten Abstands zwischen Abstandshalter und leitfähiger Struktur beim Lötvorgang, während das Lot noch flüssig ist.

Der Vorteil liegt in der Reduzierung der mechanischen Spannungen in der Scheibe, insbesondere im kritischen Bereich, der bei einem großen Lotmasseübertritt vorliegt.

Der erste thermische Ausdehnungskoeffizient ist bevorzugt von 8 x 10⁻⁶/°C bis 9 x 10⁻⁶/°C. Das Substrat ist Glas, das bevorzugt einen thermischen Ausdehnungskoeffizienten von 8,3 x 10⁻⁶/°C bis 9 x 10⁻⁶/°C in einem Temperaturbereich von 0 °C bis 300 °C aufweist.

Der zweite thermische Ausdehnungskoeffizient ist bevorzugt von 9 x 10⁻⁶/°C bis 13 x 10⁻⁶/°C, besonders bevorzugt von 10 x 10⁻⁶/°C bis 11,5 x 10⁻⁶/°C in einem Temperaturbereich von 0 °C bis 300 °C.

Die erfindungsgemäße elektrisch leitfähige Struktur weist bevorzugt eine Schichtdicke von 5 µm bis 40 µm, besonders bevorzugt von 5 µm bis 20 µm, ganz besonders bevorzugt von 8 µm bis 15 µm und insbesondere von 10 µm bis 12 µm auf. Die erfindungsgemäße elektrisch leitfähige Struktur enthält bevorzugt Silber, besonders bevorzugt Silberpartikel und Glasfritten.

Die erfindungsgemäße Schichtdicke des Lots ist < 3.0 x 10⁻⁴ m.

Die Lotmasse ist erfindungsgemäß bleifrei, enthält also kein Blei. Das ist besonders vorteilhaft im Hinblick auf die Umweltverträglichkeit der erfindungsgemäßen Scheibe mit elektrischem Anschlusselement. Bleifrei Lotmassen weisen typischerweise eine geringere Duktilität auf als bleihaltige Lotmassen, so dass mechanische Spannungen zwischen Anschlusselement und Scheibe weniger gut kompensiert werden können. Es hat sich aber gezeigt, dass kritische mechanische Spannungen durch das erfindungsgemäße Anschlusselement vermieden werden können. Die erfindungsgemäße Lotmasse enthält bevorzugt Zinn und Wismut, Indium, Zink, Kupfer, Silber oder Zusammensetzungen davon. Der Anteil an Zinn in der erfindungsgemäßen Lotzusammensetzung beträgt von 3 Gew.-% bis 99,5 Gew.-%, bevorzugt von 10 Gew.-% bis 95,5 Gew.-%, besonders bevorzugt von 15 Gew.-% bis 60 Gew.-%. Der Anteil an Wismut, Indium, Zink, Kupfer, Silber oder Zusammensetzungen davon beträgt in der erfindungsgemäßen Lotzusammensetzung von 0,5 Gew.-% bis 97

Gew.-%, bevorzugt 10 Gew.-% bis 67 Gew.-%, wobei der Anteil an Wismut, Indium, Zink, Kupfer oder Silber 0 Gew.-% betragen kann. Die erfindungsgemäße Lotzusammensetzung kann Nickel, Germanium, Aluminium oder Phosphor mit einem Anteil von 0 Gew.-% bis 5 Gew.-% enthalten. Die erfindungsgemäße Lotzusammensetzung enthält ganz besonders bevorzugt Bi40Sn57Ag3, Sn40Bi57Ag3, Bi59Sn40Ag1, Bi57Sn42Ag1, In97Ag3, Sn95,5Ag3,8Cu0,7, Bi67In33, Bi33In50Sn17, Sn77,2In20Ag2,8, Sn95Ag4Cu1, Sn99Cu1, Sn96,5Ag3,5 oder Gemische davon.

Das erfindungsgemäße Anschlusselement enthält bevorzugt zumindest 50 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän und / oder 0 Gew.-% bis 1 Gew.-% Titan. Das Anschlusselement kann zusätzlich Beimengungen weiterer Elemente enthalten, darunter Vanadium, Aluminium, Niob und Stickstoff.

Das erfindungsgemäße Anschlusselement kann auch zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und / oder 0 Gew.-% bis 1 Gew.-% Titan enthalten. Das Anschlusselement kann zusätzlich Beimengungen weiterer Elemente enthalten, darunter Vanadium, Aluminium und Stickstoff.

In einer weiteren bevorzugten Ausgestaltung enthält das erfindungsgemäße Anschlusselement zumindest 65 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1 Gew.-% Molybdän und / oder 0 Gew.-% bis 1 Gew.-% Titan. Das Anschlusselement kann zusätzlich Beimengungen weiterer Elemente enthalten, darunter Vanadium, Aluminium, Niob und Stickstoff.

Das erfindungsgemäße Anschlusselement kann auch zumindest 73 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1 Gew.-% Molybdän, 0 Gew.-% bis 1 Gew.-% Niob und / oder 0 Gew.-% bis 1 Gew.-% Titan enthalten. Das Anschlusselement kann zusätzlich Beimengungen weiterer Elemente enthalten, darunter Vanadium, Aluminium und Stickstoff.

In einer weiteren, besonders bevorzugten Ausgestaltung enthält das erfindungsgemäße Anschlusselement zumindest 75 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan und / oder 0 Gew.-% bis 1 Gew.-% Titan. Das Anschlusselement kann zusätzlich Beimengungen weiterer Elemente enthalten, darunter Vanadium, Aluminium, Niob und Stickstoff.

Das erfindungsgemäße Anschlusselement kann auch zumindest 78,5 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob und / oder 0 Gew.-% bis 1 Gew.-% Titan enthalten. Das Anschlusselement kann zusätzlich Beimengungen weiterer Elemente enthalten, darunter Vanadium, Aluminium und Stickstoff.

Das erfindungsgemäße Anschlusselement ist bevorzugt mit Nickel, Zinn, Kupfer und / oder Silber beschichtet. Das erfindungsgemäße Anschlusselement ist besonders bevorzugt mit einer haftvermittelnden Schicht, bevorzugt aus Nickel und / oder Kupfer, und zusätzlich mit einer lötbaren Schicht, bevorzugt aus Silber, versehen. Das erfindungsgemäße Anschlusselement ist ganz besonders bevorzugt mit 0,1 µm bis 0,3 µm Nickel und / oder 3 µm bis 20 µm Silber beschichtet. Das Anschlusselement kann vernickelt, verzinnt, verkupfert und / oder versilbert werden. Nickel und Silber verbessern die Stromtragfähigkeit und Korrosionsstabilität des Anschlusselements und die Benetzung mit der Lotmasse.

Das erfindungsgemäße Anschlusselement enthält einen chromhaltigen Stahl bevorzugt mit einem Anteil an Chrom von größer oder gleich 10,5 Gew.-% und einem thermischen Ausdehnungskoeffizienten von 9 x 10⁻⁶/°C bis 13 x 10⁻⁶/°C. Weitere Legierungsbestandteile wie Molybdän, Mangan oder Niob führen zu einer verbesserten Korrosionsbeständigkeit oder veränderten mechanischen Eigenschaften, wie Zugfestigkeit oder Kaltumformbarkeit.

Der Vorteil von Anschlusselementen aus chromhaltigem Stahl gegenüber Anschlusselementen nach dem Stand der Technik aus Titan liegt in der besseren Lötbarkeit. Sie ergibt sich aus der höheren Wärmeleitfähigkeit von 25 W/mK bis 30 W/mK im Vergleich zur Wärmeleitfähigkeit des Titans von 22 W/mK. Die höhere Wärmeleitfähigkeit führt zu einer gleichmäßigeren Erwärmung des Anschlusselements während des Lötvorgangs, wodurch die punktuelle Ausbildung besonders heißer Stellen ("hot spots") vermieden wird. Diese Stellen sind Ausgangspunkte für mechanische Spannungen und spätere Beschädigungen der Scheibe. Es ergibt sich eine verbesserte Haftung des Anschlusselements an der Scheibe, insbesondere bei der Verwendung einer bleifreien Lotmasse, die aufgrund ihrer geringeren Duktilität im Vergleich zu bleihaltigen Lotmassen mechanische Spannungen weniger gut kompensieren kann. Chromhaltiger Stahl ist zudem gut schweißbar. Dadurch ist eine bessere Verbindung des Anschlusselements mit der Bordelektrik über ein elektrisch leitfähiges Material, beispielsweise Kupfer, durch Verschweißen möglich. Aufgrund der besseren Kaltumformbarkeit kann das Anschlusselement auch besser mit dem elektrisch leitfähigen Material vercrimpt werden. Chromhaltiger Stahl ist zudem besser verfügbar.

Ein weiterer Vorteil von Anschlusselementen aus chromhaltigem Stahl liegt in der hohen Steifigkeit im Vergleich zu vielen herkömmlichen Anschlusselementen. Dadurch kann das Anschlusselement weniger leicht verformt werden, beispielsweise unter Belastung durch Zug an einem mit dem Anschlusselement verbundenen Kabel. Eine solche Verformung führt zu einer Belastung der Verbindung zwischen Anschlusselement und elektrisch leitfähiger Struktur über die Lotmasse. Insbesondere bei bleifreien Lotmassen muss eine solche Belastung vermieden werden. Die Belastung kann infolge der geringeren Duktilität der bleifreien Lotmasse im Vergleich zu bleihaltigen Lotmassen weniger gut kompensiert werden, was zu Beschädigungen der Scheibe führen kann.

Der chromhaltige Stahl kann auch als Ausgleichsplatte auf ein Anschlusselement aus beispielsweise Stahl, Aluminium, Titan, Kupfer angeschweißt, gecrimpt oder geklebt werden. Als Bimetall kann ein günstiges Ausdehnungsverhalten des Anschlusselementes relativ zur Glasausdehnung erzielt werden. Die Ausgleichsplatte ist bevorzugt hutförmig.

Das elektrische Anschlusselement enthält auf der zur Lotmasse ausgerichteten Fläche eine Beschichtung, die Kupfer, Zink, Zinn, Silber, Gold oder Legierungen oder Schichten davon, bevorzugt Silber enthält. Dadurch wurde eine Ausbreitung der Lotmasse über die Beschichtung hinweg verhindert und die Austrittsbreite begrenzt.

Das elektrische Anschlusselement kann in Brückenform mit mindestens zwei Kontaktflächen, aber auch als Anschlusselement mit einer Kontaktfläche ausgestaltet sein.

Die Anschlusselemente sind in der Draufsicht beispielsweise bevorzugt 1 mm bis 50 mm lang und breit und besonders bevorzugt 3 mm bis 30 mm lang und breit und ganz besonders bevorzugt 2 mm bis 5 mm breit und 12 mm bis 24 mm lang.

Die Form des elektrischen Anschlusselementes kann Lotdepots im Zwischenraum von Anschlusselement und elektrisch leitfähiger Struktur ausbilden. Die Lotdepots und Benetzungseigenschaften des Lotes am Anschlusselement verhindern den Austritt der Lotmasse aus dem Zwischenraum. Lotdepots können rechtwinklig, verrundet oder polygonal ausgestaltet sein.

Die Verteilung der Lotwärme und damit die Verteilung der Lotmasse im Lötvorgang kann durch die Form des Anschlusselementes definiert werden. Lotmasse fließt zum wärmsten Punkt. Beispielsweise kann die Brücke eine Einfach- oder Doppelhutform aufweisen, um die Wärme während des Lötvorgangs vorteilhaft im Anschlusselement zu verteilen.

Das Einbringen der Energie beim elektrischen Verbinden von elektrischem Anschlusselement und elektrisch leitfähiger Struktur erfolgt bevorzugt mit Stempel, Thermoden, Kolbenlöten, bevorzugt Laserlöten, Heißluftlöten, Induktionslöten, Widerstandslöten und/oder mit Ultraschall.

Die Aufgabe der Erfindung wird weiter durch ein Verfahren zur Herstellung einer erfindungsgemässen Scheibe gelöst, wobei
a) die bleifreie Lotmasse auf mindestens eine Kontaktfläche des Anschlusselements als Plättchen mit festgelegter Schichtdicke, Volumen, Form und Anordnung aufgebracht wird,
b) die elektrisch leitfähige Struktur auf das Substrat aufgebracht wird,
c) das Anschlusselement mit der Lotmasse auf der elektrisch leitfähigen Struktur angeordnet wird und
d) das Anschlusselement mit der elektrisch leitfähigen Struktur verlötet wird.

Die Lotmasse wird bevorzugt vorher auf die Anschlusselemente appliziert, bevorzugt als Plättchen mit festgelegter Schichtdicke, Volumen, Form und Anordnung auf dem Anschlusselement.

Das Anschlusselement kann beispielsweise mit einem Blech, einer Litze oder einem Geflecht aus beispielsweise Kupfer verschweißt oder gecrimpt werden und mit der Bordelektrik verbunden werden.

Das Anschlusselement wird bevorzugt in Heizscheiben oder in Scheiben mit Antennen in Automobilen, Eisenbahnen, Flugzeugen oder Seefahrzeugen benutzt. Das Anschlusselement dient dazu, die leitenden Strukturen der Scheibe mit elektrischen Systemen zu verbinden, welche außerhalb der Scheibe angeordnet sind. Die elektrischen Systeme sind Verstärker, Steuereinheiten oder Spannungsquellen.

Eine bevorzugte Ausgestaltung der Erfindung ist eine Scheibe mit einem Anschlusselement, wobei die Kontaktfläche des Anschlusselementes keine Ecken aufweist. Das elektrische Anschlusselement ist dabei über eine Kontaktfläche vollflächig mit einem Teilbereich der elektrisch leitfähigen Struktur verbunden. Die Kontaktfläche kann eine ovale, bevorzugt eine elliptische und insbesondere eine kreisförmige Struktur aufweisen. Alternativ kann die Kontaktfläche eine konvexe polygonale Form, bevorzugt rechteckige Form, mit abgerundeten Ecken aufweisen. Die abgerundeten Ecken weisen einen Krümmungsradius von r > 0.5 mm, bevorzugt von r > 1 mm auf.

Die Erfindung wird anhand einer Zeichnung und Ausführungsbeispielen näher erläutert. Es zeigen:
Fig. 1 eine perspektivische Darstellung einer ersten Ausgestaltung der erfindungsgemäßen Scheibe,
Fig. 1a eine perspektivische Darstellung einer alternativen Ausgestaltung der erfindungsgemäßen Scheibe,
Fig. 2 einen Schnitt A-A' durch die Scheibe gemäß der Figur 1,
Fig. 3 einen Schnitt durch eine alternative erfindungsgemäße Scheibe,
Fig. 4 einen Schnitt durch eine weitere alternative erfindungsgemäße Scheibe,
Fig. 5 einen Schnitt durch eine weitere alternative erfindungsgemäße Scheibe,
Fig. 6 eine perspektivische Darstellung einer alternativen Ausgestaltung der erfindungsgemäßen Scheibe,
Fig. 7 einen Schnitt B-B' durch die Scheibe gemäß der Figur 6,
Fig. 8 einen Schnitt C-C' durch die Scheibe gemäß der Figur 1,
Fig. 9 einen Schnitt D-D' durch die Scheibe gemäß der Figur 1a,
Fig. 9a einen Schnitt durch eine alternative Ausführung der erfindungsgemäßen Scheibe,
Fig. 9b eine Draufsicht auf eine alternative Ausführung des Anschlusselements,
Fig. 10 eine Draufsicht auf eine alternative Ausgestaltung der erfindungsgemäßen Scheibe mit ellipsenförmigem Anschlusselement,
Fig. 11 einen Schnitt E-E' durch die Scheibe gemäß der Figur 10,
Fig. 12 einen Schnitt durch eine alternative erfindungsgemäße Scheibe,
Fig. 13 einen Schnitt durch eine weitere alternative erfindungsgemäße Scheibe,
Fig. 14 eine Draufsicht auf eine alternative Ausführung des Anschlusselements,
Fig. 15 eine Draufsicht auf eine weitere alternative Ausführung des Anschlusselements,
Fig. 16 eine Draufsicht auf eine weitere alternative Ausführung des Anschlusselements,
Fig. 17 eine Seitenansicht des Anschlusselements der Figur 16 und
Fig. 18 einen Schnitt durch eine weitere alternative erfindungsgemäße Scheibe mit gewölbtem Anschlusselement,
Fig. 19 eine perspektivische Darstellung eine weitere alternative Ausführung des Anschlusselements und
Fig. 20 ein detailliertes Flussdiagramm des erfindungsgemäßen Verfahrens.

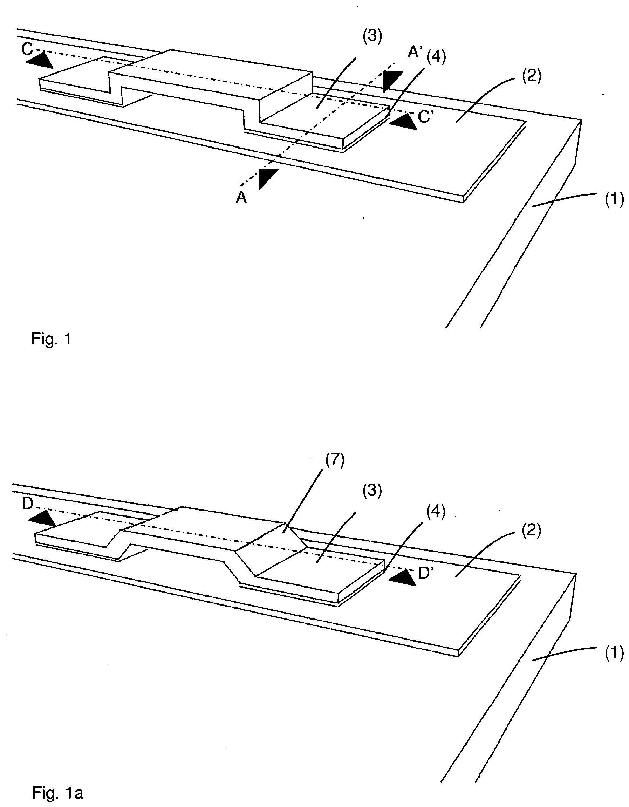

Fig.1, Fig. 2 und Fig. 8 zeigen je ein Detail einer erfindungsgemäßen beheizbaren Scheibe 1 im Bereich des elektrischen Anschlusselementes 3. Die Scheibe 1 ist ein 3 mm dickes thermisch vorgespanntes Einscheibensicherheitsglas aus Natron-Kalk-Glas. Die Scheibe 1 weist eine Breite von 150 cm und eine Höhe von 80 cm auf. Auf der Scheibe 1 ist eine elektrisch leitfähige Struktur 2 in Form einer Heizleiterstruktur 2 aufgedruckt. Die elektrisch leitfähige Struktur 2 enthält Silberpartikel und Glasfritten. Im Randbereich der Scheibe 1 ist die elektrisch leitfähige Struktur 2 auf eine Breite von 10 mm verbreitert und bildet eine Kontaktfläche für das elektrische Anschlusselement 3. Im Randbereich der Scheibe 1 befindet sich weiter ein nicht dargestellter Abdecksiebdruck. Im Bereich der Kontaktfläche 8 zwischen dem elektrischen Anschlusselement 3 und der elektrisch leitfähigen Struktur 2 ist Lotmasse 4 aufgebracht, die eine dauerhafte elektrische und mechanische Verbindung zwischen dem elektrischen Anschlusselement 3 und der elektrisch leitfähigen Struktur 2 bewirkt. Die Lotmasse 4 enthält 57 Gew.-% Wismut, 40 Gew.-% Zinn und 3 Gew.-% Silber. Die Lotmasse 4 ist durch ein vorgegebenes Volumen und Form vollständig zwischen dem elektrischen Anschlusselement 3 und der elektrisch leitfähigen Struktur 2 angeordnet. Die Lotmasse 4 hat eine Dicke von 250 µm. Das elektrische Anschlusselement 3 besteht aus Stahl der Werkstoff-Nummer 1.4509 nach EN 10 088-2 (ThyssenKrupp Nirosta® 4509) mit einem thermischen Ausdehnungskoeffizienten von 10,0 x 10⁻⁶/°C. Das elektrische Anschlusselement 3 ist brückenförmig ausgestaltet und hat eine Breite von 4 mm und eine Länge von 24 mm.

Stahl der Werkstoff-Nummer 1.4509 nach EN 10 088-2 ist gut kaltumformbar und gut schweißbar mit allen Verfahren außer Gasschweißung. Der Stahl wird für den Bau von Schalldämpfer- und Abgasentgiftungsanlagen eingesetzt und ist dafür aufgrund der Zunderbeständigkeit bis über 950 °C und Korrosionsbeständigkeit gegen die im Abgassystem auftretenden Beanspruchungen besonders geeignet. Es können aber auch andere chromhaltige Stähle für das Anschlusselement 3 verwendet werden. Ein alternativer besonders geeigneter Stahl ist beispielsweise Stahl der Werkstoffnummer 1.4016 nach EN 10 088-2.

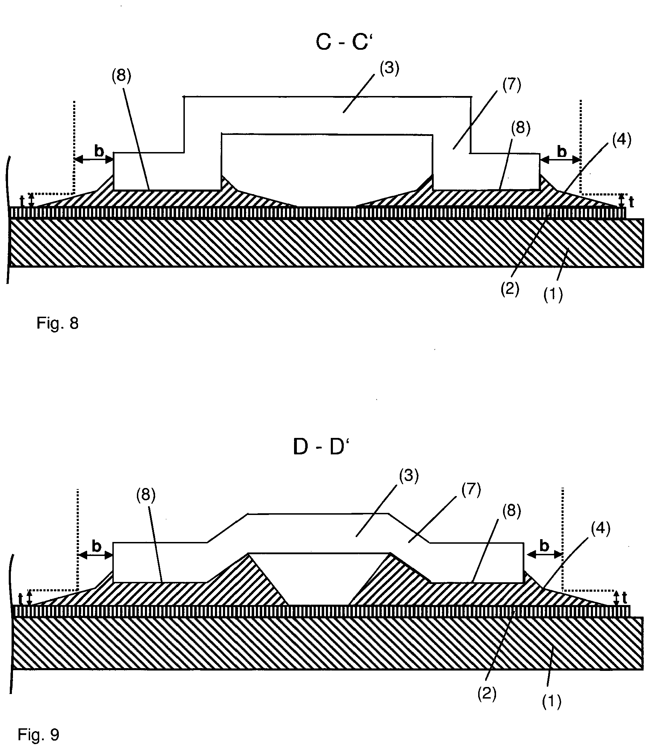

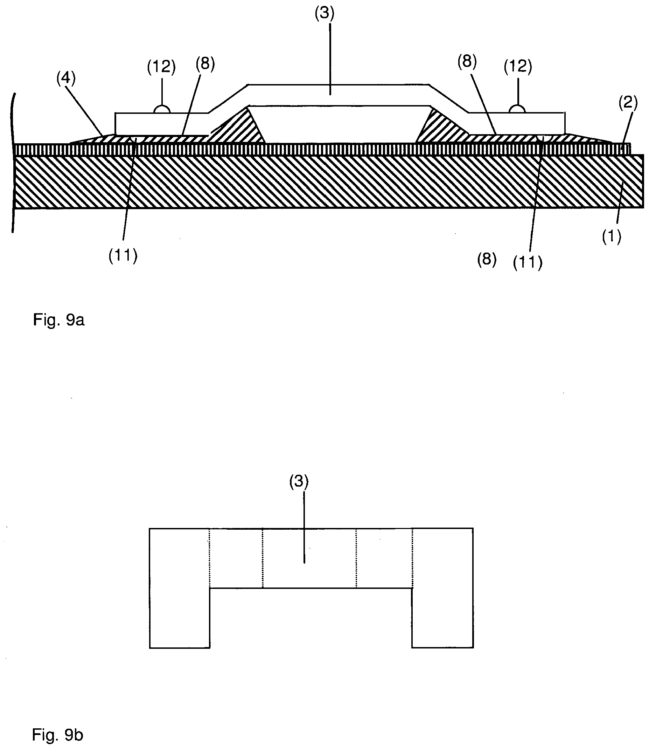

Fig. 1a und Fig. 9 zeigen je ein Detail einer alternativen Ausgestaltung der erfindungsgemäßen beheizbaren Scheibe 1 im Bereich des elektrischen Anschlusselementes 3. Der Bereich 7 des brückenförmigen Anschlusselementes 3 ist schräg zur Oberfläche der Scheibe ausgeformt. Dadurch wird aufgrund des Kapillareffektes die Ausbildung einer dickeren Schicht an Lotmasse 4 im Volumen, das von der elektrisch leitfähigen Struktur 2 und Bereich 7 des Anschlusselementes begrenzt wird, erreicht. Dadurch wird der Lotmasseübertritt an den Au ßenkanten des Anschlusselements verringert, was vorteilhaft zu einer Reduzierung der mechanischen Spannungen in der Scheibe führt. Das ist insbesondere bei der Verwendung einer bleifreien Lotmasse vorteilhaft, die aufgrund ihrer geringeren Duktilität im Vergleich zu bleihaltigen Lotmassen mechanische Spannungen weniger gut kompensieren kann. Der höhenvermittelnde Bereich 7 des brückenförmigen Anschlusselementes 3 muss nicht notwendigerweise als planer Abschnitt ausgebildet sein, sondern kann auch eine Krümmung aufweisen. Der Winkel zwischen der Oberfläche des Substrats 1 und jeder der Tangentialebenen der zum Substrat 1 hingewandten Flächen der Bereiche 7 beträgt bevorzugt kleiner 90°, besonders bevorzugt zwischen 2° und 75°, ganz besonders bevorzugt zwischen 5° und 50°.

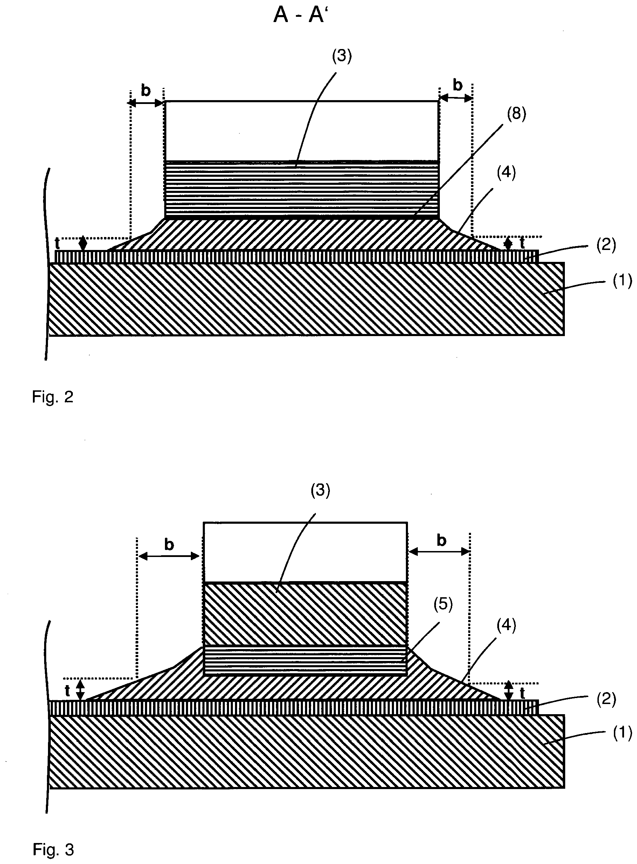

Fig. 3 zeigt in Fortführung des Ausführungsbeispiels der Figuren 1 und 2 eine alternative Ausgestaltung des erfindungsgemäßen Anschlusselementes 3. Das elektrische Anschlusselement 3 ist auf der zur Lotmasse 4 hin ausgerichteten Fläche mit einer silberhaltigen Beschichtung 5 versehen. Dadurch wird eine Ausbreitung der Lotmasse über die Beschichtung 5 hinweg verhindert und die Austrittsbreite b begrenzt. In einer weiteren Ausgestaltung kann sich zwischen Anschlusselement 3 und silberhaltiger Schicht 5 eine haftvermittelnde Schicht, beispielsweise aus Nickel und / oder Kupfer, befinden. Die Austrittsbreite b der Lotmasse 4 ist unterhalb von 1 mm. Aufgrund der Anordnung der Lotmasse 4 werden keine kritischen mechanischen Spannungen in der Scheibe 1 beobachtet. Die Verbindung der Scheibe 1 mit dem elektrischen Anschlusselement 3 ist über die elektrisch leitfähige Struktur 2 dauerhaft stabil.

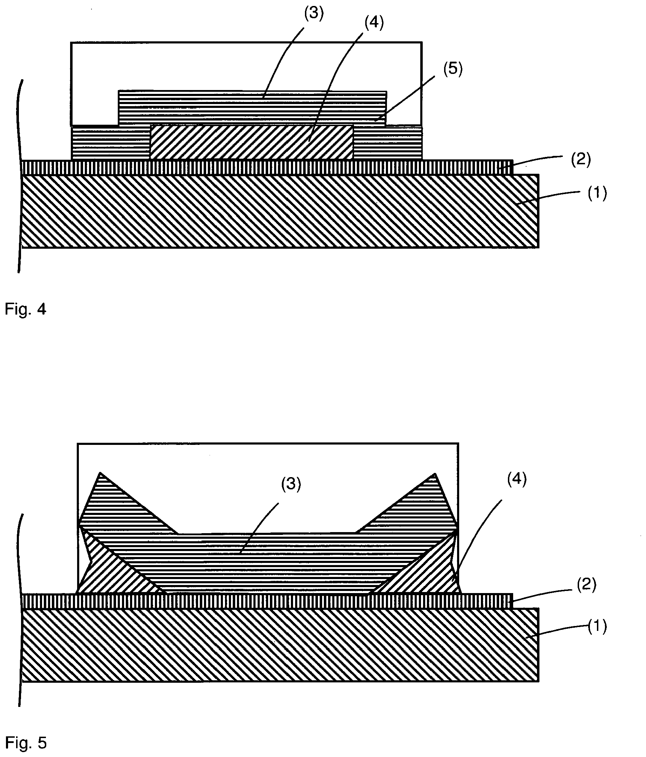

Fig. 4 zeigt in Fortführung des Ausführungsbeispiels der Figuren 1 und 2 eine weitere alternative Ausgestaltung des erfindungsgemäßen Anschlusselementes 3. Das elektrische Anschlusselement 3 enthält auf der zur Lotmasse 4 hin ausgerichteten Fläche eine Aussparung mit einer Tiefe von 250 µm, die ein Lotdepot für die Lotmasse 4 bildet. Ein Austritt der Lotmasse 4 aus dem Zwischenraum kann vollständig verhindert werden. Die thermischen Spannungen in der Scheibe 1 sind unkritisch und es wird eine dauerhafte elektrische und mechanische Verbindung zwischen den Anschlusselement 3 und der Scheibe 1 über die elektrisch leitfähige Struktur 2 bereitgestellt.

Fig. 5 zeigt in Fortführung des Ausführungsbeispiels der Figuren 1 und 2 eine weitere alternative Ausgestaltung des erfindungsgemäßen Anschlusselementes 3. Das elektrische Anschlusselement 3 ist an den Randbereichen aufgebogen. Die Höhe der Aufbiegung der Randbereiche von der Glasscheibe 1 beträgt maximal 400 µm. Dadurch wird ein Raum für die Lotmasse 4 gebildet. Die vorgegebene Lotmasse 4 bildet zwischen dem elektrischen Anschlusselement 3 und der elektrisch leitfähigen Struktur 2 einen konkaven Meniskus. Ein Austritt von Lotmasse 4 aus dem Zwischenraum kann vollständig verhindert werden. Die Austrittsbreite b ist in etwa 0, größtenteils aufgrund des gebildeten Meniskus unterhalb von null. Die thermischen Spannungen in der Scheibe 1 sind unkritisch und es wird eine dauerhafte elektrische und mechanische Verbindung zwischen dem Anschlusselement 3 und der Scheibe 1 über die elektrisch leitfähige Struktur 2 bereitgestellt.

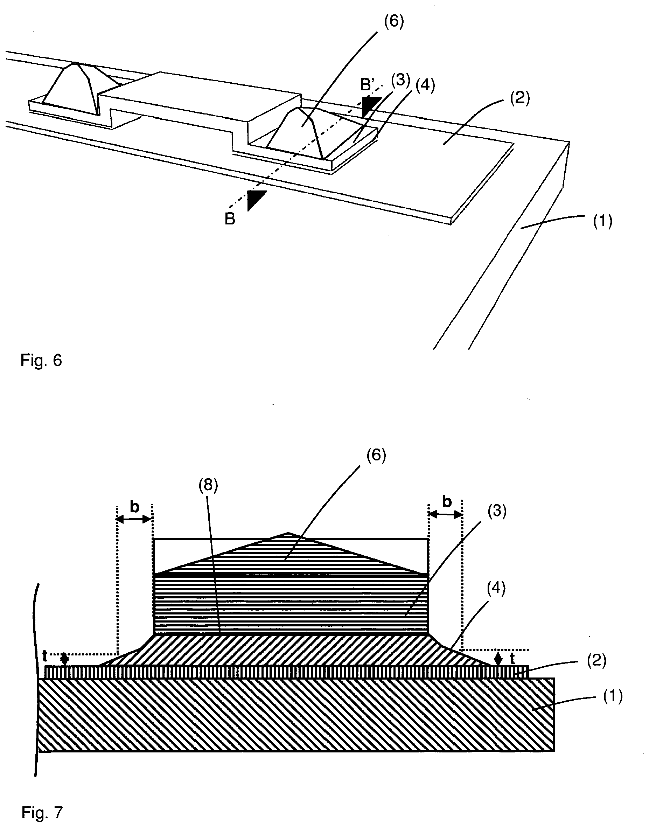

Fig. 6 und Fig. 7 zeigen je ein Detail einer weiteren Ausgestaltung der erfindungsgemäßen Scheibe 1 mit Anschlusselement 3 in Brückenform. Das Anschlusselement 3 enthält eine eisenhaltige Legierung mit einem thermischen Ausdehnungskoeffizienten von 8 x 10⁻⁶/°C. Die Materialdicke beträgt 2 mm. Im Bereich der Kontaktfläche 8 des Anschlusselementes 3 mit der elektrisch leitfähigen Struktur 2 sind hutförmige Ausgleichskörper 6 mit chromhaltigem Stahl der Werkstoff-Nummer 1.4509 nach EN 10 088-2 (ThyssenKrupp Nirosta® 4509) aufgebracht. Die maximale Schichtdicke der hutförmigen Ausgleichskörper 6 beträgt 4 mm. Durch die Ausgleichskörper können die thermischen Ausdehnungskoeffizienten des Anschlusselementes 3 den Erfordernissen der Scheibe 1 und der Lotmasse 4 angepasst werden. Die hutförmigen Ausgleichskörper 6 führen zu einem verbesserten Wärmefluss während der Herstellung der Lotverbindung 4. Die Erwärmung erfolgt vor allem im Zentrum der Kontaktfläche 8. Die Austrittsbreite b der Lotmasse 4 kann weiter reduziert werden. Aufgrund der geringen Austrittsbreite b von < 1 mm und des angepassten Ausdehnungskoeffizienten können die thermischen Spannungen in der Scheibe 1 weiter reduziert werden. Die thermischen Spannungen in der Scheibe 1 sind unkritisch und es wird eine dauerhafte elektrische und mechanische Verbindung zwischen dem Anschlusselement 3 und der Scheibe 1 über die elektrisch leitfähige Struktur 2 bereitgestellt.

Fig. 9a zeigt in Fortführung des Ausführungsbeispiels der Figuren 1a und 9 eine alternative Ausgestaltung des erfindungsgemäßen Anschlusselementes 3. An jeder der den Kontaktfläche 8 gegenüberliegenden, vom Substrat 1 angewandten Flächen der planen Fußbereiche des Anschlusselements 3 ist ein Kontakterhebung 12 angeordnet. Die Kontakterhebungen 12 sind in der gezeigten Ausgestaltung als Halbkugeln ausgeformt und haben eine Höhe von 2,5 x 10⁻⁴ m und eine Breite von 5 x 10⁻⁴ m. Die Mittelpunkte der Kontakterhebungen 12 sind etwa in der geometrischen Mitte der vom Substrat 1 angewandten Flächen der planen Fußbereiche des Anschlusselements 3 angeordnet. Die Kontakterhebungen 12 ermöglichen aufgrund ihrer konvexen Oberfläche ein vorteilhaft verbessertes Verlöten des Anschlusselements 3 mit der elektrisch leitfähigen Struktur 2. Zum Löten können Elektroden verwendet werden, deren Kontaktseite flach ausgeformt ist. Die Elektrodenfläche wird mit der Kontakterhebung 12 in Kontakt gebracht, wobei der Kontaktbereich zwischen Elektrodenfläche und Kontakterhebung 12 die Lötstelle bildet. Die Position der Lötstelle wird dabei bevorzugt durch den Punkt auf der konvexen Oberfläche der Kontakterhebung 12 bestimmt, der den größten lotrechten Abstand zur Oberfläche des Substrats 1 aufweist. Die Position der Lötstelle ist unabhängig von der Position der Lötelektrode auf dem Anschlusselement 3. Das ist besonders vorteilhaft im Hinblick auf eine reproduzierbare, gleichmäßige Wärmeverteilung während des Lötvorgangs.

Die Wärmeverteilung während des Lötvorgangs wird durch die Position, die Größe, die Anordnung und die Geometrie der Kontakterhebung 12 bestimmt. In alternativen Ausgestaltungen kann die Kontakterhebung 12 beispielsweise als Segment eines Rotationsellipsoids oder als Quader ausgeformt sein, wobei die vom Substrat abgewandte Fläche des Quaders konvex gekrümmt ausgeformt ist. Die Kontakterhebungen 12 haben bevorzugt eine Höhe von 0,1 mm bis 2 mm, besonders bevorzugt von 0,2 mm bis 1 mm. Die Länge und Breite der Kontakterhebungen 12 beträgt bevorzugt zwischen 0,1 und 5 mm, ganz besonders bevorzugt zwischen 0,4 mm und 3 mm.

Auf jeder der Kontaktflächen 8 sind Abstandshalter 11 angeordnet. Es können beispielsweise drei Abstandshalter 11 auf jeder Kontaktfläche 8 angeordnet sein, von denen im in der Figur dargestellten Schnitt ein Abstandshalter 11 zu erkennen ist. Die Abstandshalter 11 sind als Halbkugeln ausgeformt und haben eine Höhe von 2,5 x 10⁻⁴ m und eine Breite von 5 x 10⁻⁴ m. Die Abstandshalter 11 können in alternativen Ausgestaltungen auch beispielsweise als Würfel, als Pyramide oder als Segment eines Rotationsellipsoids ausgestaltet sein und bevorzugt eine Breite von 0,5 x 10⁻⁴ m bis 10 x 10⁻⁴ m und eine Höhe von 0,5 x 10⁻⁴ m bis 5 x 10⁻⁴ m, besonders bevorzugt von 1 x 10⁻⁴ m bis 3 x 10⁻⁴ m aufweisen. Durch die Abstandshalter 11 wird die Ausbildung einer gleichmäßigen Schicht der Lotmasse 4 begünstigt. Das ist besonders vorteilhaft in Hinblick auf die Haftung des Anschlusselements 3.

Die Kontakterhebungen 12 und die Abstandshalter 11 können in einer vorteilhaften Ausgestaltung einstückig mit dem Anschlusselement 3 ausgebildet sein. Die Kontakterhebungen 12 und die Abstandshalter 11 können beispielsweise durch Umformen eines Anschlusselementes 3 mit im Ausgangszustand planer Oberfläche auf der Oberfläche ausgebildet werden, beispielsweise durch Prägen oder Tiefziehen. Dabei kann eine entsprechende Vertiefung auf der der Kontakterhebung 12 beziehungsweise dem Abstandshalter 11 gegenüberliegenden Oberfläche des Anschlusselements 3 erzeugt werden.

Durch die Kontakterhebungen 12 und die Abstandshalter 11 wird eine homogene, gleichmäßig dicke und gleichmäßig aufgeschmolzene Schicht der Lotmasse 4 erreicht. Dadurch können mechanische Spannungen zwischen Anschlusselement 3 und Substrat 1 verringert werden. Das ist insbesondere bei der Verwendung bleifreier Lotmassen besonders vorteilhaft, die aufgrund ihrer geringeren Duktilität im Vergleich zu bleihaltigen Lotmassen mechanische Spannungen weniger gut kompensieren können.

Fig. 9b zeigt in Fortführung des Ausführungsbeispiels der Figuren 1a und 9 eine Draufsicht auf eine alternative Ausgestaltung des erfindungsgemäßen Anschlusselements 3. Das Anschlusselement 3 ist brückenförmig ausgestaltet und weist einen Querschnitt gemäß der Figur 9 auf. Der Abgrenzungen zwischen den planen Teilabschnitten sind in der Draufsicht durch gestrichelte Linien gezeigt. Die planen Fußbereiche des Anschlusselementes 3, an deren Unterseite die Kontaktflächen 8 angeordnet sind, haben eine Breite von 8 mm und sind doppelt so breit wie der Brückenbereich zwischen den Fußbereichen. Es hat sich überraschend gezeigt, dass Fußbereiche, die breiter ausgestaltet sind als der Brückenbereich zu einer Verringerung der mechanischen Spannungen in der Scheibe 1 führen. Die Breite der Fußbereiche beträgt dabei bevorzugt von 150 % bis 300 % der Breite des Brückenbereichs.

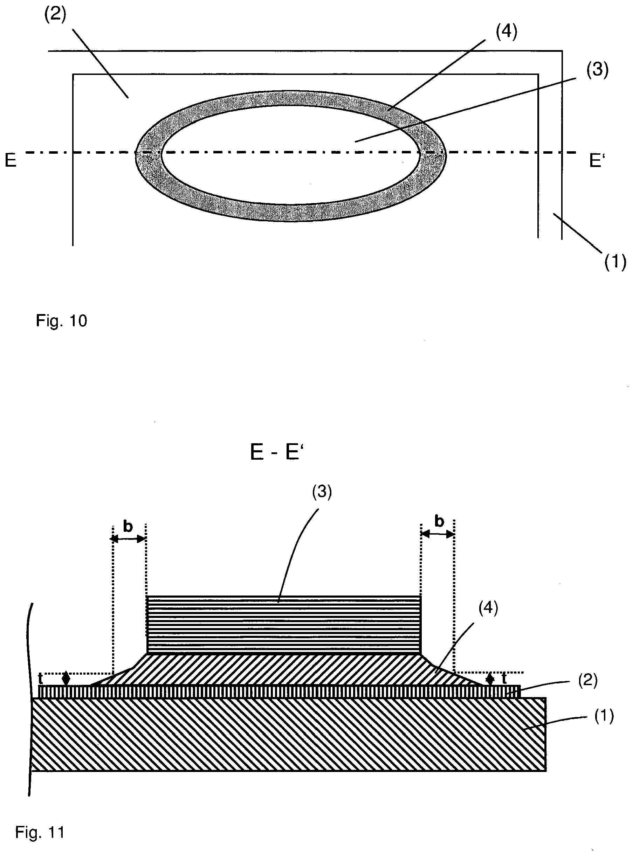

Fig.10 und Fig. 11 zeigen je ein Detail einer weiteren Ausgestaltung der erfindungsgemäßen beheizbaren Scheibe 1 im Bereich des elektrischen Anschlusselementes 3. Ein Austritt der Lotmasse 4 aus dem Zwischenraum zwischen dem elektrischen Anschlusselement 3 und der elektrisch leitfähigen Struktur 2, die eine Schichtdicke t von 50 µm übersteigt, wird auf einer maximalen Austrittsbreite von b = 0,5 mm beobachtet. Das elektrische Anschlusselement 3 besteht aus Stahl der Werkstoff-Nummer 1.4509 nach EN 10 088-2 (ThyssenKrupp Nirosta® 4509). Das elektrische Anschlusselement 3 ist mit einer ellipsenförmigen Grundfläche ausgestaltet. Die Länge der Hauptachse beträgt 12 mm, die Länge der Nebenachse 5 mm. Die Materialdicke des Anschlusselementes 3 beträgt 0,8 mm. Durch die Anordnung der Lotmasse 4, vorgegeben durch das Anschlusselement 3 und die elektrisch leitfähige Struktur 2, werden keine kritischen mechanischen Spannungen in der Scheibe 1 beobachtet. Die Verbindung der Scheibe 1 mit dem elektrischen Anschlusselement 3 ist über die elektrisch leitfähige Struktur 2 dauerhaft stabil.

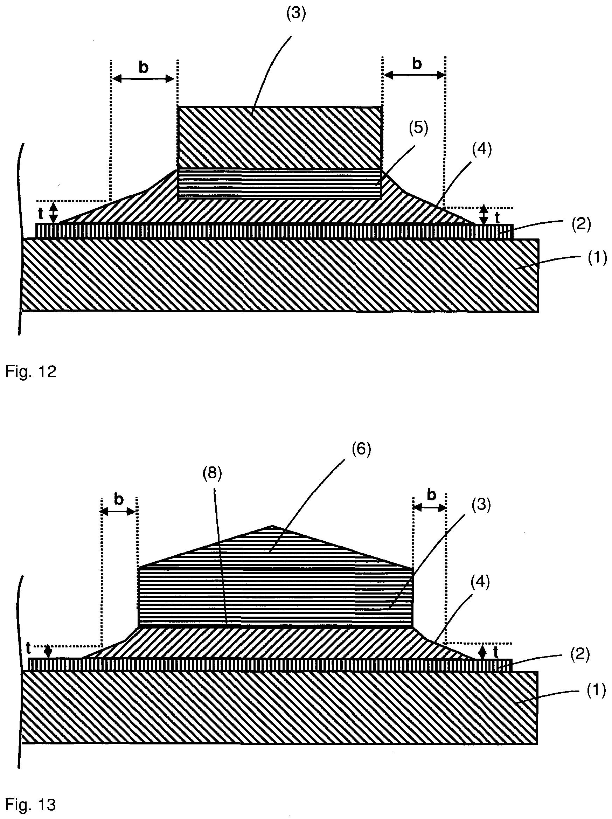

Fig. 12 zeigt in Fortführung des Ausführungsbeispiels der Figuren 10 und 11 eine alternative Ausgestaltung des erfindungsgemäßen Anschlusselementes 3. Das elektrische Anschlusselement 3 ist auf der zur Lotmasse 4 hin ausgerichteten Fläche mit einer silberhaltigen Beschichtung 5 versehen. Dadurch wird eine Ausbreitung der Lotmasse über die Beschichtung 5 hinweg verhindert und die Austrittsbreite b begrenzt. Die Austrittsbreite b der Lotmasse 4 ist unterhalb von 1 mm. Aufgrund der Anordnung der Lotmasse 4 werden keine kritischen mechanischen Spannungen in der Scheibe 1 beobachtet. Die Verbindung der Scheibe 1 mit dem elektrischen Anschlusselement 3 ist über die elektrisch leitfähige Struktur 2 dauerhaft stabil.

Fig. 13 zeigt in Fortführung des Ausführungsbeispiels der Figuren 10 und 11 eine weitere Ausgestaltung der erfindungsgemäßen Scheibe 1 mit einem Anschlusselement 3 mit ellipsenförmiger Grundfläche. Das Anschlusselement 3 enthält eine eisenhaltige Legierung mit einem thermischen Ausdehnungskoeffizienten von 8 x 10⁻⁶/°C. Die Materialdicke beträgt 2 mm. Im Bereich der Kontaktfläche 8 des Anschlusselementes 3 mit der elektrisch leitfähigen Struktur 2 ist ein hutförmiger Ausgleichskörper 6 mit chromhaltigem Stahl der Werkstoff-Nummer 1.4509 nach EN 10 088-2 (ThyssenKrupp Nirosta® 4509) aufgebracht. Die maximale Schichtdicke des hutförmigen Ausgleichskörpers 6 beträgt 4 mm. Durch den Ausgleichskörper können die thermischen Ausdehnungskoeffizienten des Anschlusselementes 3 den Erfordernissen der Scheibe 1 und der Lotmasse 4 angepasst werden. Der hutförmige Ausgleichskörper 6 führt zu einem verbesserten Wärmefluss während der Herstellung der Lotverbindung 4. Die Erwärmung erfolgt vor allem im Zentrum der Kontaktfläche 8. Die Austrittsbreite b der Lotmasse 4 kann weiter reduziert werden. Aufgrund der geringen Austrittsbreite b von < 1 mm und des angepassten Ausdehnungskoeffizienten können die thermischen Spannungen in der Scheibe 1 weiter reduziert werden. Die thermischen Spannungen in der Scheibe 1 sind unkritisch und es wird eine dauerhafte elektrische und mechanische Verbindung zwischen dem Anschlusselement 3 und der Scheibe 1 über die elektrisch leitfähige Struktur 2 bereitgestellt.

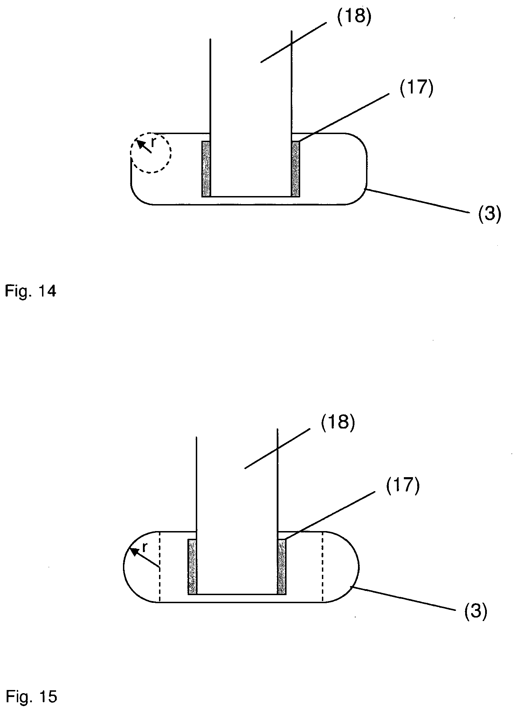

Fig. 14 zeigt eine Draufsicht auf eine alternative Ausführung des erfindungsgemäßen Anschlusselements 3. Das Anschlusselement 3 ist rechteckförmig ausgestaltet und hat eine Breite von 5 mm und eine Länge von 14 mm. Die Ecken des Rechtecks sind jeweils mit einem Kreissegment mit Krümmungsradius r von beispielsweise 1 mm abgerundet. Außerdem ist ein Anschlusskabel 18 über einen Verschweißungsbereich 17 mit dem Anschlusselement 3 verschweißt. Der Verschweißungsbereich 17 hat eine Breite von 3 mm und eine Länge von 6 mm. Das Anschlusskabel 18 ist ein Gewebekabel aus dünnen, verzinnten Kupferdrähten. Es können aber auch Litzenkabel oder Drähte als Anschlusskabel 18 verwendet werden. Alternativ können auch metallische Hülsen, Steckerverbinder oder Crimpanschlüsse mit dem Anschlusselement 3 elektrisch leitend verbunden werden. Insbesondere kann das Anschlusselement 3 auch als ein- oder mehrteilige Klemmhülse oder Crimpelement ausgestaltet sein.

Fig. 15 zeigt eine Draufsicht auf eine weitere alternative Ausführungsform des erfindungsgemäßen Anschlusselements 3. Das Anschlusselement 3 ist rechteckförmig gestaltet, wobei die beiden kurzen Seiten des Rechtecks halbkreisförmig ausgestaltet sind. Das Anschlusselement hat eine Breite von 5 mm und eine Länge von 14 mm. Der Verschweißungsbereich 17 hat eine Breite von 3 mm und eine Länge von 6 mm.

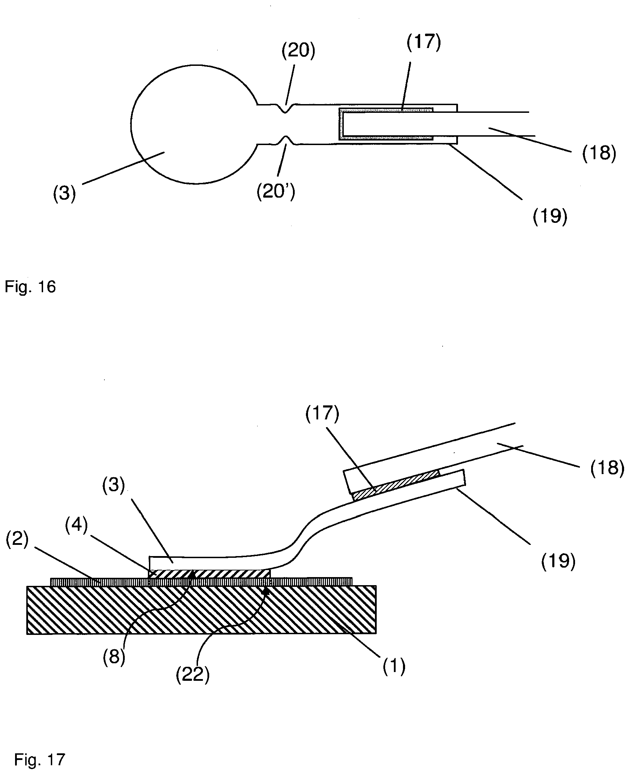

Fig. 16 und Fig. 17 zeigen eine weitere alternative Ausgestaltung des erfindungsgemäßen Anschlusselements 3 mit einer Anschlussfahne 19. Die Kontaktfläche 8 des Anschlusselements 3 ist kreisförmig ausgebildet. Der Radius des Kreises beträgt 4 mm. Die Anschlussfahne 19 ist über einen Verschweißungsbereich 17 mit einem Anschlusskabel 18 verbunden. Alternativ kann die Anschlussfahne 19 auch als Flachstecker sowie als Klemmhülse oder Crimpanschluss ausgestaltet sein. Die Anschlussfahne 19 weist in dieser Ausführung zwei Einkerbungen 20, 20' auf. Diese Einkerbungen 20, 20' dienen zur Reduktion des Material der Anschlussfahne 19. Dies führt zu einer Federwirkung und damit zur Abfederung von Kräften, die über das Anschlusskabel 18 auf den Lötkontakt weitergeleitet werden.

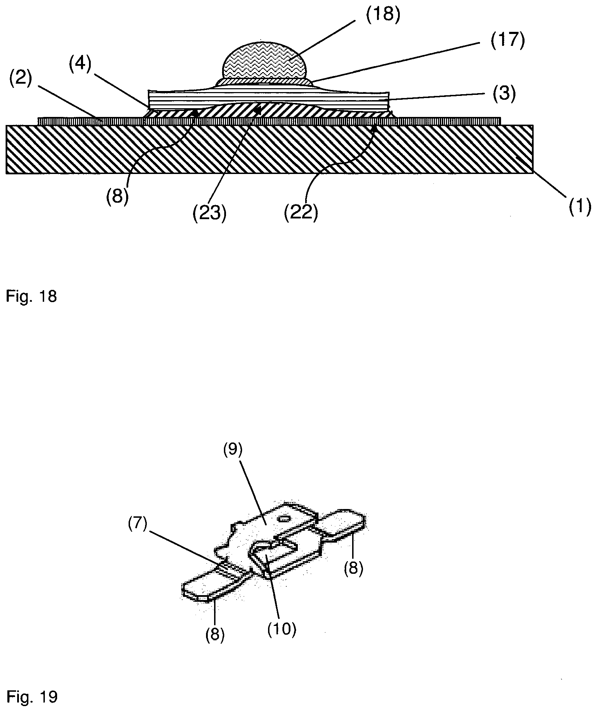

Fig. 18 zeigt einen Schnitt durch eine weitere alternative Ausgestaltung eines erfindungsgemäßen Anschlusselements 3. Das Anschlusselement 3 weist in der Mitte eine Wölbung 23 auf. Im Bereich der Wölbung 23 ist die Lotmasse 4 verdickt.

Fig. 19 zeigt eine perspektivische Darstellung einer alternativen Ausgestaltung des erfindungsgemäßen Anschlusselements 3. Das Anschlusselement 3 ist brückenförmig ausgestaltet und weist einen ersten und einen zweiten planen Fußbereich mit beispielsweise einer Länge von 7 mm und einer Breite von 5 mm auf, an deren Unterseite die beiden Kontaktflächen 8 angeordnet sind. Die planen Fußbereiche sind über einen Brückenbereich miteinander verbunden, welcher einen planen Abschnitt mit beispielsweise einer Länge von 12 mm und einer Breite von 10 mm umfasst. Der plane Abschnitt des Brückenbereichs weist eine herstellungsbedingte Aussparung 10 auf. Die Aussparung 10 verläuft bis zu der Kante des planen Abschnitts des Brückenbereichs, an die sich der erste Fußbereich über einen höhenvermittelnden Übergangsbereich 7 anschließt. Die Aussparung 10 entspricht in Form und Größe dem Abschnitt des Anschlusselementes 3 aus dem ersten Fußbereich und dem höhenvermittelnden Übergangsbereich 7. Die Kontaktflächen 8 weisen eine rechteckige Form auf, wobei die beiden jeweils vom Brückenbereich abgewandten Ecken abgefast sind. Durch die Abfasung werden zu kleine Winkel, insbesondere 90°-Winkel entlang der umlaufenden Seitenkanten der Kontaktflächen 8 vermieden. Es hat sich gezeigt, dass dadurch mechanische Spannungen in der Scheibe verringert werden können.

Das Anschlusselement 3 enthält einen auf dem Brückenbereich angeordneten Anschlussstecker 9. Der Anschlussstecker 9 ist an der dem ersten Fußbereich zugewandten Seitenkante des planen Abschnitts des Brückenbereichs mit dem planen Abschnitt des Brückenbereichs verbunden. Der Anschlussstecker 9 ist als normgerechter Flachsteckverbinder ausgestaltet, auf welchen die Kupplung eines nicht dargestellten Verbindungskabels beispielsweise zur Bordelektrik aufgesteckt werden kann.

Der besondere Vorteil der Ausgestaltung der Erfindung liegt in einer einfachen Herstellung des Anschlusselementes 3 bei gleichzeitiger Bereitstellung einer komfortablen Schnittstelle zur elektrischen Kontaktierung (Anschlussstecker 9). Die Fußbereiche, der Brückenbereich und der Anschlussstecker 9 sind einstückig ausgebildet. Das Anschlusselement 3 wird in einem planen Ausgangszustand bereitgestellt, in dem die als erster Fußbereich und höhenvermittelnder Übergangsbereich 7 vorgesehenen Abschnitte innerhalb der Aussparung 10 angeordnet sind. Der Anschlussstecker 9 ist im Ausgangszustand in der gleichen Ebene wie der plane Abschnitt des Brückenbereichs angeordnet. Der als erster Fußbereich und höhenvermittelnder Übergangsbereich 7 vorgesehene Bereich kann vom planen Abschnitt des Brückenbereichs getrennt werden, beispielsweise durch Ausstanzen, Laserbearbeitung oder Wasserstrahlbearbeitung, wobei eine Verbindung über die Verbindungskante zwischen höhenvermittelndem Übergangsbereich 7 und planem Abschnitt des Brückenbereich bestehen bleibt. Der Anschlussstecker 9 wird um die Verbindungslinie zwischen Anschlussstecker 9 und planem Abschnitt des Brückenbereichs in die dargestellt Position gebogen, wobei die im Ausgangszustand nach oben weisende Fläche dem Brückenbereich zugewandt wird. Der erste Fußbereich und der höhenvermittelnde Übergangsbereich 7 werden über die Verbindungslinie zwischen höhenvermittelndem Übergangsbereich 7 und planem Abschnitt des Brückenbereich in die dargestellte Position gebogen, wobei die im Ausgangszustand nach oben weisende Fläche anschließend die Unterseiten des ersten Fußbereichs und des höhenvermittelnden Übergangsbereichs 7 bilden. Durch das Umbiegen des ersten Fußbereichs wird die Aussparung 10 gebildet. Der zweite Fußbereich und der entsprechende höhenvermittelnde Übergangsbereich 7 werden ebenfalls aus dem planen Ausgangszustand in die dargestellt Position gebogen.

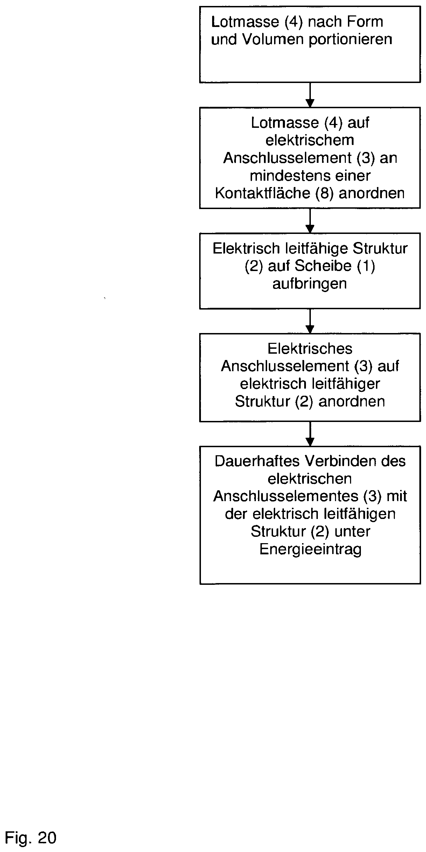

Fig. 20 zeigt detailliert ein erfindungsgemäßes Verfahren zur Herstellung einer Scheibe 1 mit elektrischem Anschlusselement 3. Dort wird ein Beispiel für das erfindungsgemäße Verfahren zur Herstellung einer Scheibe mit einem elektrischen Anschlusselement 3 dargestellt. Als erster Schritt ist es notwendig, die Lotmasse 4 nach Form und Volumen zu portionieren. Die portionierte Lotmasse 4 wird auf die Kontaktflächen 8 des elektrischen Anschlusselementes 3 angeordnet. Das elektrische Anschlusselement 3 wird mit der Lotmasse 4 auf der elektrisch leitfähigen Struktur 2 angeordnet. Es erfolgt eine dauerhafte Verbindung des elektrischen Anschlusselementes 3 mit der elektrisch leitfähigen Struktur 2 und dadurch mit der Scheibe 1 unter Energieeintrag.

### Beispiel

Testproben wurden angefertigt mit der Scheibe 1 (Dicke 3 mm, Breite 150 cm und Höhe 80 cm), der elektrisch leitfähigen Struktur 2 in Form einer Heizleiterstruktur, dem elektrischen Anschlusselement 3 gemäß Figur 1, der Silberschicht 5 auf den Kontaktflächen 8 des Anschlusselements 3 und der Lotmasse 4. Die Materialdicke des Anschlusselementes 3 betrug 0,8 mm. Die Kontaktfläche 8 des Anschlusselements 3 wies eine Breite von 4 mm und eine Länge von 4 mm auf. Die Lotmasse 4 wurde vorher als Plättchen mit festgelegter Schichtdicke, Volumen und Form auf der Kontaktfläche 8 des Anschlusselements 3 aufgebracht. Das Anschlusselement 3 wurde mit der angebrachten Lotmasse 4 auf der elektrisch leitfähigen Struktur 2 angebracht. Das Anschlusselement 3 wurde bei einer Temperatur von 200 °C und einer Behandlungsdauer von 2 Sekunden auf der elektrisch leitfähigen Struktur 2 angelötet. Ein Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde nur auf einer maximalen Austrittsbreite von b = 0,5 mm beobachtet. Die Ausmaße und Zusammensetzungen des elektrischen Anschlusselements 3, der Silberschicht 5 auf den Kontaktflächen 8 des Anschlusselements 3 und der Lotmasse 4 gehen aus der Tabelle 1 hervor. Durch die Anordnung der Lotmasse 4, vorgegeben durch das Anschlusselement 3 und die elektrisch leitfähige Struktur 2, wurden keine kritischen mechanischen Spannungen in der Scheibe 1 beobachtet. Die Verbindung der Scheibe 1 mit dem elektrischen Anschlusselement 3 war über die elektrisch leitfähige Struktur 2 dauerhaft stabil.

Das Anschlusselement 3 gemäß Figur 1a zeigte aufgrund des Kapillareffektes eine bessere Haftung zwischen Anschlusselement 3 und Substrat 1. Aufgrund der Anordnung der Lotmasse 4 wurden keine kritischen mechanischen Spannungen in der Scheibe 1 beobachtet. Die Verbindung der Scheibe 1 mit dem elektrischen Anschlusselement 3 war über die elektrisch leitfähige Struktur 2 dauerhaft stabil.

Bei sämtlichen Proben konnte bei einem Temperaturunterschied von +80 °C auf -30 °C beobachtet werden, dass kein Glassubstrat 1 brach oder Schäden aufwies. Es konnte gezeigt werden, dass kurz nach dem Anlöten diese Scheiben 1 mit angelöteten Anschlusselement 3 gegen plötzlichen Temperaturabfall stabil waren.

**Tabelle 1**

| Bestandteile | Material | Beispiel |
|---|---|---|
| Anschlusselement 3 | | |
| | Stahl der Werkstoff-Nummer 1.4509 nach EN 10 088-2 mit der Zusammensetzung: | |
| | Eisen (Gew.-%) | 78,87 |
| | Kohlenstoff (Gew.-%) | 0,03 |
| | Chrom (Gew.-%) | 18,5 |
| | Titan (Gew.-%) | 0,6 |
| | Niob (Gew.-%) | 1 |
| | Mangan (Gew.-%) | 1 |
| | CTE (coefficient of thermal expansion) (10⁻⁶/°C für 0 °C - 100 °C) | 10 |
| | Differenz zwischen CTE Anschlusselement und Substrat (10⁻⁶/°C, für 0 °C - 100 °C) | 1,7 |
| | Wärmeleitfähigkeit (W/mK für 20 °C) | 25 |
| | Dicke des Anschlusselements (m) | 8,0 x 10⁻⁴ |

| Benetzungsschicht 5 | | |
|---|---|---|
| | Silber (Gew.-%) | 100 |
| | Dicke der Schicht (m) | 7,0 x 10⁻⁶ |

| Lotmasse 4 | | |
|---|---|---|
| | Zinn (Gew.-%) | 40 |
| | Wismut (Gew.-%) | 57 |
| | Silber (Gew.-%) | 3 |
| | Dicke der Lotschicht in (m) | 250 x 10⁻⁶ |
| | Die Dicke der Benetzungsschicht und der Lotschicht (m) | 257 x 10⁻⁶ |

| Glas Substrat 1 | | |
|---|---|---|
| (Natron-Kalk-Glas) | | |
| | CTE (10⁻⁶/°C für 0 °C - 320 °C) | 8,3 |

### Vergleichsbeispiel

Das Vergleichsbeispiel wurde genauso durchgeführt wie das Beispiel. Der Unterschied lag in der Verwendung eines anderen Materials für das Anschlusselement 3. Das Anschlusselement 3 bestand zu 100 Gew.-% aus Titan. Das Anschlusselement 3 hatte damit eine geringere Wärmeleitfähigkeit, einen geringeren thermischen Ausdehnungskoeffizienten und einen geringeren Unterschied der thermischen Ausdehnungskoeffizienten zwischen Anschlusselement 3 und Substrat 1. Die Ausmaße und Bestandteile des elektrischen Anschlusselements 3, der Metallschicht auf den Kontaktflächen 8 des Anschlusselements 3 und der Lotmasse 4 gehen aus der Tabelle 2 hervor. Das Anschlusselement 3 wurde mit der elektrisch leitfähigen Struktur 2 nach herkömmlichen Verfahren mittels der Lotmasse 4 verlötet. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 2 mm bis 3 mm erhalten. Die geringere Wärmeleitfähigkeit des Materials für das Anschlusselement führte im Vergleichsbeispiel zu einer weniger gleichmäßigen Erwärmung des Anschlusselements während des Lötvorgangs.

Bei einem plötzlichen Temperaturunterschied von +80 °C auf -30 °C wurde beobachtet, dass die Glassubstrate 1 kurz nach dem Anlöten überwiegend Schäden aufwiesen.

**Tabelle 2**

| Bestandteile | Material | Vergleichsbeispiel |
|---|---|---|
| Anschlusselement 3 | | |
| | Titan (Gew.-%) | 100 |
| | CTE (coefficient of thermal expansion) (10⁻⁶/°C für 0 °C - 100 °C) | 8,80 |
| | Differenz zwischen CTE des Anschlusselements und des Substrats (10⁻⁶/°C für 0 °C - 100 °C) | 0,5 |
| | Wärmeleitfähigkeit (W/mK für 20 °C) | 22 |
| | Dicke des Anschlusselements (m) | 8,0 x 10⁻⁴ |

| Benetzungsschicht 5 | | |
|---|---|---|
| | Silber (Gew.-%) | 100 |
| | Dicke der Schicht (m) | 7,0 x 10⁻⁶ |

| Lotmasse 4 | | |
|---|---|---|
| | Zinn (Gew.-%) | 40 |
| | Wismut (Gew.-%) | 57 |
| | Silber (Gew.-%) | 3 |
| | Dicke der Lotschicht in (m) | 250 x 10⁻⁶ |
| | Die Dicke der Benetzungsschicht und der Lotschicht (m) | 257 x 10⁻⁶ |

| Glas Substrat 1 | | |
|---|---|---|
| (Natron-Kalk-Glas) | | |
| | CTE (10⁻⁶/°C für 0 °C - 320 °C) | 8,3 |

Die Unterschiede aus den vorstehenden Tabellen 1 und 2 und die Vorteile des erfindungsgemäßen Anschlusselementes 3 gehen aus der Tabelle 3 hervor.

**Tabelle 3**

| | Erfindungsgemäße Ausführung, Beispiel | Vergleichsbeispiel |
|---|---|---|
| Material | Stahl der Werkstoff-Nummer 1.4509 nach EN 10 088-2 | Titan |
| Wärmeleitfähigkeit (W/mK für 20 °C) | 25 | 22 |
| CTE (coefficient of thermal expansion) des Anschlusselements (10⁻⁶/°C für 0 °C - 100 °C) | 10 | 8,8 |
| Differenz zwischen CTE des Anschlusselements und des Substrats (10⁻⁶/°C für 0 °C - 100 °C) | 1,7 | 0,5 |

Es hat sich gezeigt, dass erfindungsgemäße Scheiben mit Glassubstraten 1 und erfindungsgemäßen elektrischen Anschlusselementen 3 eine bessere Stabilität gegen plötzliche Temperaturunterschiede aufwiesen. Dieses Ergebnis war für den Fachmann unerwartet und überraschend.

### Bezugszeichenliste

(1) Scheibe
(2) Elektrisch leitfähige Struktur
(3) Elektrisches Anschlusselement
(4) Lotmasse
(5) Benetzungsschicht
(6) Ausgleichskörper
(7) Bereich des elektrischen Anschlusselements 3
(8) Kontaktfläche des Anschlusselements 3 mit der elektrisch leitfähigen Struktur 2
(9) Anschlussstecker
(10) Aussparung
(11) Abstandshalter
(12) Kontakterhebung
(17) Verschweißungsbereich
(18) Anschlusskabel
(19) Anschlussfahne
(20) Einkerbung
(20') Einkerbung
(22) Teilbereich von 2
(23) Wölbung

b maximale Austrittsbreite der Lotmasse
t Grenzdicke der Lotmasse
r Krümmungsradius

A-A' Schnittlinie
B-B' Schnittlinie
C-C' Schnittlinie
D-D' Schnittlinie
E-E' Schnittlinie

## Patentansprüche

1. Eine Scheibe für Fahrzeuge mit mindestens einem elektrischen Anschlusselement, umfassend:
- ein Substrat (1) aus Glas,
- eine elektrisch leitfähige Struktur (2) auf einem Bereich des Substrats (1), wobei die elektrisch leitfähige Struktur (2) ein Heizleiter oder Antennenleiter ist,
- ein Anschlusselement (3), wobei das Anschlusselement (3) zumindest einen chromhaltigen Stahl enthält und
- eine Schicht einer bleifreien Lotmasse (4), die das Anschlusselement (3) mit Teilbereichen der elektrisch leitfähigen Struktur (2) elektrisch verbindet.

2. Scheibe nach Anspruch 1, wobei das Substrat (1) Flachglas, Floatglas, Quarzglas, Borosilikatglas oder Kalk-Natron-Glas enthält.

3. Scheibe nach einem der Ansprüche 1 oder 2, wobei die Differenz zwischen dem thermischen Ausdehnungskoeffizienten des Substrats (1) und dem thermischen Ausdehnungskoeffizienten des Anschlusselements (3) < 5 x 10⁻⁶/°C ist.

4. Scheibe nach einem der Ansprüche 1 bis 3, wobei das Anschlusselement (3) zumindest 50 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän oder 0 Gew.-% bis 1 Gew.-% Titan enthält.

5. Scheibe nach Anspruch 4, wobei das Anschlusselement (3) zumindest 75 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan oder 0 Gew.-% bis 1 Gew.-% Titan enthält.

6. Scheibe nach einem der Ansprüche 1 bis 5, wobei die elektrisch leitfähige Struktur (2) Silber enthält.

7. Scheibe nach einem der Ansprüche 1 bis 6, wobei die Schichtdicke des Lots (4) < 3.0 x 10⁻⁴ m ist.

8. Scheibe nach einem der Ansprüche 1 bis 7, wobei die Lotmasse (4) Zinn und Wismut, Indium, Zink, Kupfer, Silber oder Zusammensetzungen davon enthält.

9. Scheibe nach Anspruch 8, wobei der Anteil an Zinn in der Lotzusammensetzung (4) 3 Gew.-% bis 99,5 Gew.-% beträgt und der Anteil von Wismut, Indium, Zink, Kupfer, Silber oder Zusammensetzungen davon 0,5 Gew.-% bis 97 Gew.-% beträgt.

10. Scheibe nach einem der Ansprüche 1 bis 9, wobei das Anschlusselement (3) mit Nickel, Zinn, Kupfer und / oder Silber beschichtet ist.

11. Scheibe nach Anspruch 10, wobei das Anschlusselement (3) mit 0,1 µm bis 0,3 µm Nickel und / oder 3 µm bis 20 µm Silber beschichtet ist.

12. Scheibe nach einem der Ansprüche 1 bis 11, wobei das Anschlusselement (3) über mindestens eine Kontaktfläche (8) vollflächig mit dem Teilbereich (22) der elektrisch leitfähigen Struktur (2) verbunden ist.

13. Scheibe nach einem der Ansprüche 1 bis 12, wobei die Kontaktfläche (8) keine Ecken aufweist.

14. Verfahren zur Herstellung einer Scheibe nach einem der Ansprüche 1 bis 13, wobei
a) die bleifreie Lotmasse (4) auf mindestens eine Kontaktfläche (8) des Anschlusselements (3) als Plättchen mit festgelegter Schichtdicke, Volumen, Form und Anordnung aufgebracht wird,
b) die elektrisch leitfähige Struktur (2) auf das Substrat (1) aufgebracht wird,
c) das Anschlusselement (3) mit der Lotmasse (4) auf der elektrisch leitfähigen Struktur (2) angeordnet wird und
d) das Anschlusselement (3) mit der elektrisch leitfähigen Struktur (2) verlötet wird.

## Claims

1. A pane for vehicles with at least one electrical connection element, comprising:
- a substrate (1) of glass,
- an electrically conductive structure (2) on a region of the substrate (1), wherein the electrically conductive structure (2) is a heating conductor or an antenna conductor,
- a connection element (3), wherein the connection element (3) contains at least a chromium-containing steel, and
- a layer of a lead-free solder material (4), which electrically connects the connection element (3) to subregions of the electrically conductive structure (2).

2. Pane according to claim 1, wherein the substrate (1) contains flat glass, float glass, quartz glass, borosilicate glass or soda lime glass.

3. Pane according to one of claims 1 or 2, wherein the difference between the coefficient of thermal expansion of the substrate (1) and the coefficient of thermal expansion of the connection element (3) is < 5 x 10⁻⁶/°C.

4. Pane according to one of claims 1 through 3, wherein the connection element (3) contains at least 50 wt.-% to 89.5 wt.-% iron, 10.5 wt.-% to 20 wt.-% chromium, 0 wt.-% to 1 wt.-% carbon, 0 wt.-% to 5 wt.-% nickel, 0 wt.-% to 2 wt.-% manganese, 0 wt.-% to 2.5 wt.-% molybdenum, or 0 wt.-% to 1 wt.-% titanium.

5. Pane according to claim 4, wherein the connection element (3) contains at least 75 wt.-% to 84 wt.-% iron, 16 wt.-% to 18.5 wt.-% chromium, 0 wt.-% to 0.1 wt.-% carbon, 0 wt.-% to 1 wt.-% manganese, or 0 wt.-% to 1 wt.-% titanium.

6. Pane according to one of claims 1 through 5, wherein the electrically conductive structure (2) contains silver.

7. Pane according to one of claims 1 through 6, wherein the layer thickness of the solder (4) is < 3.0 x 10⁻⁴ m.

8. Pane according to one of claims 1 through 7, wherein the solder material (4) contains tin and bismuth, indium, zinc, copper, silver, or compositions thereof.

9. Pane according to claim 8, wherein the proportion of tin in the solder composition (4) is 3 wt.-% to 99.5 wt.-% and the proportion of bismuth, indium, zinc, copper, silver, or compositions thereof is 0.5 wt.-% to 97 wt.-%.

10. Pane according to one of claims 1 through 9, wherein the connection element (3) is coated with nickel, tin, copper, and / or silver.

11. Pane according to claim 10, wherein the connection element (3) is coated with 0.1 µm to 0.3 µm nickel and / or 3 µm to 20 µm silver.

12. Pane according to one of claims 1 through 11, wherein the connection element (3) is connected to the subregion (22) of the electrically conductive structure (2) via at least one contact surface (8) over its entire surface.

13. Pane according to one of claims 1 through 12, wherein the contact surface (8) has no corners.

14. Method for production of a pane according to one of claims 1 through 13, wherein
a) the lead-free solder material (4) is applied on at least one contact surface (8) of the connection element (3) as a platelet with a fixed layer thickness, volume, shape, and arrangement,
b) the electrically conductive structure (2) is applied on the substrate (1),
c) the connection element (3) is arranged with the solder material (4) on the electrically conductive structure (2), and
d) the connection element (3) is soldered to the electrically conductive structure (2).

## Revendications

1. Une vitre pour les véhicules avec au moins un élément de raccordement électrique, comprenant:
- un substrat (1) de verre,
- une structure électriquement conductrice (2) sur une région du substrat (1), où la structure électriquement conductrice (2) est un conducteur chauffant ou un conducteur d'antenne,
- un élément de connexion (3), où l'élément de connexion (3) contient au moins un acier contenant du chrome et
- une couche d'une masse de brasure sans plomb (4), qui relie électriquement l'élément de connexion (3) avec des zones partielles de la structure électriquement conductrice (2).

2. Vitre selon la revendication 1, où le substrat (1) contient du verre plat, du verre flotté, du verre de quartz, du verre borosilicaté ou du verre silico-sodo-calcique.

3. Vitre selon l'une des revendications 1 ou 2, où la différence entre le coefficient thermique de dilatation du substrat (1) et le coefficient de dilatation thermique de l'élément de connexion (3) est <5x10 ⁻⁶/°C.

4. Vitre selon l'une des revendications 1 à 3, où l'élément de connexion (3) contient au moins 50% à 89,5% en poids de fer, 10,5% à 20% en poids de chrome, 0% à 1% en poids de carbone, 0% à 5% en poids de nickel, 0% à 2% en poids de manganèse, 0% à 2,5% en poids de molybdène ou 0% à 1% en poids de titane.

5. Vitre selon la revendication 4, où l'élément de connexion (3) contient au moins 75% à 84% en poids de fer, 16% à 18,5% en poids de chrome, 0% à 0,1% en poids de carbone, 0% à 1% en poids de manganèse, ou 0% à 1% en poids de titane.

6. Vitre selon l'une des revendications 1 à 5, où la structure conductrice (2) contient de l'argent.

7. Vitre selon l'une des revendications 1 à 6, où l'épaisseur de la couche de brasure (4) est <3.0 x 10⁻⁴ m.

8. Vitre selon l'une des revendications 1 à 7, où la masse de brasure (4) contient du bismuth, de l'indium, du zinc, du cuivre, de l'argent ou des composites de ceux-ci.

9. Vitre selon la revendication 8, où la proportion d'étain contenu dans la composition de la brasure (4) est de 3% à 99,5% en poids et la part de bismuth, indium, zinc, cuivre, argent ou des combinaisons de ceux-ci est de 0,5% à 97,5% en poids.

10. Vitre selon l'une des revendications 1 à 9, où l'élément de connexion (3) est recouvert de nickel, d'étain, de cuivre et/ou d'argent.

11. Vitre selon la revendication 10, où l'élément de connexion (3) est recouvert de 0,1 µm à 0,3 µm de nickel et/ou de 3 µm à 20 µm d'argent.

12. Vitre selon l'une des revendications 1 à 11, où l'élément de connexion (3) est relié sur au moins une surface de contact (8) sur toute sa surface avec une zone partielle (22) de la structure électriquement conductrice (2).

13. Vitre selon l'une des revendications 1 à 12, où la surface de contact (8) n'a aucuns coins.

14. Procédé de fabrication d'une vitre selon l'une des revendications 1 à 13, où
a) la masse de brasure sans plomb (4) est appliqué à au moins une surface de contact (8) de l'élément de connexion (3) comme plaquette avec épaisseur de couche, volume, forme et disposition fixes,
b) la structure conductrice (2) est appliquée sur le substrat (1),
c) l'élément de connexion (3) est disposé avec la masse de brasure (4) sur la structure électriquement conductrice (2) et
d) l'élément de connexion (3) est soudé avec la structure électriquement conductrice (2).
